# EUROPÄISCHE PATENTSCHRIFT

(11) **EP 2 736 770 B1**
(45) Veröffentlichungstag und Bekanntmachung des Hinweises auf die Patenterteilung: **31.08.2016**
(21) Anmeldenummer: 12746275.2
(22) Anmeldetag: 26.07.2012
(51) Int. Cl.: B60R 16/033

(54) **ENERGIEVERSORGUNGSSCHALTUNG FÜR ELEKTRISCHE KOMPONENTEN**
ENERGY SUPPLY CIRCUIT FOR ELECTRIC COMPONENTS
CIRCUIT D'ALIMENTATION EN ÉNERGIE POUR COMPOSANTS ÉLECTRIQUES

(30) Priorität: 27.07.2011 DE 102011108577
(43) Veröffentlichungstag der Anmeldung: 04.06.2014
(73) Patentinhaber: Marquardt GmbH, 78604 Rietheim-Weilheim (DE)
(72) Erfinder: MÜLLER, Karl, 78628 Rottweil-Neufra (DE); RECKERMANN, Matthias, 78573 Wurmlingen (DE)
(74) Vertreter: Otten, Roth, Dobler & Partner mbB Patentanwälte
(86) Internationale Anmeldenummer: PCT/EP2012/003162
(87) Internationale Veröffentlichungsnummer: WO 2013/013824

(56) Entgegenhaltungen:
- EP-A2- 2 284 052
- US-A- 5 191 500
- US-A1- 2010 082 198
- US-A1- 2011 127 830

## Beschreibung

Die Erfindung betrifft eine Energieversorgungsschaltung nach dem Oberbegriff des Patentanspruchs 1.

Eine solche Energieversorgungsschaltung kann insbesondere in einem Kraftfahrzeug für die Strom- und/oder Spannungsversorgung von Steuergeräten verwendet werden.

Strom- und/oder Spannungsversorgungsschaltungen für elektrische Komponenten sind bereits in unterschiedlichen Ausgestaltungen bekannt geworden. Derartige Strom- und/oder Spannungsversorgungsschaltungen im Kraftfahrzeug umfassen regelmäßig einen Akku bzw. eine Batterie und sind auf die individuellen Erfordernisse der jeweiligen zu versorgenden elektrischen Komponente angepasst. Bei Fehlfunktionen kann es vorkommen, dass der Akku vollständig entleert wird und das Kraftfahrzeug dadurch funktionsuntüchtig wird.

Aus der US 2010/0082198 A1 ist eine Energieversorgungsschaltung bekannt, bei der eine Entladeüberwachungsschaltung vorgesehen ist, die die im Akku gespeicherte Energie überwacht. Bei Unterschreiten eines Grenzwertes für die im Akku gespeicherte Energie schaltet die Entladeüberwachungsschaltung die Energieversorgung zumindest einzelner Komponenten ab. Weitere Energieversorgungsschaltungen, bei denen die Energieversorgung einer Hilfsbatterie abschaltbar ist, sind in der EP 2 284 052 A2 sowie in der US 2011/0127830 A1 beschrieben. Schließlich ist in der US 5 191 500 A die Energieversorgung zur Sicherung eines Speichers für ein Telefon in einem Kraftfahrzeug beschrieben.

Der Erfindung liegt die Aufgabe zugrunde, die Energieversorgungsschaltung derart weiterzuentwickeln, dass zumindest ein Notbetrieb ermöglicht ist.

Diese Aufgabe wird bei einer gattungsgemäßen Energieversorgungsschaltung durch die kennzeichnenden Merkmale des Anspruchs 1 gelöst.

Bei der erfindungsgemäßen Energieversorgungsschaltung wird die im Akku enthaltene Restenergie auf Anforderung einer je nach Art des Notbetriebs bestimmten Komponente zur Verfügung gestellt. Vorteilhafterweise wird dadurch eine vollständige Entleerung des Akkus vermieden, so dass immer noch eine Restenergie vorhanden ist, die dann für den Notbetrieb verwendet werden kann. Soweit zweckmäßig kann auch die Energieversorgung aller zugehörigen Komponenten abgeschaltet werden. Mit Hilfe der erfindungsgemäßen Energieversorgung wird folglich die Zuverlässigkeit des Kraftfahrzeugs gesteigert. Selbstverständlich kann die Entladeüberwachungsschaltung dem Fahrer des Kraftfahrzeugs die Notsituation anzeigen, so dass dieser mit Hilfe des Notbetriebs eine Werkstatt aufsuchen kann. Weitere Ausgestaltungen der Erfindung sind Gegenstand der Unteransprüche.

Eine solche Betriebsweise für den Notbetrieb ist besonders für ein Kraftfahrzeug mit einem Schließsystem, und zwar insbesondere für die Zugangs- und/oder Fahrberechtigung, geeignet. Das Schließsystem umfasst eine wenigstens zwei Zustände besitzende, als Steuereinrichtung ausgebildete erste Einrichtung, wie eine Steuereinrichtung zur Ent- und/oder Verriegelung der Autotüren, des Zündschlosses, der Lenkradverriegelung, zur Freigabe und/oder Sperrung der Wegfahrsperre, des Motorsteuergeräts o. dgl., und eine zugehörige, in der Art eines elektronischen Schlüssels, eines ID-Gebers, einer Chipkarte o. dgl. ausgebildete zweite Einrichtung. Die beiden Einrichtungen besitzen zu deren bestimmungsgemäßen Betrieb Sender und/oder Empfänger für insbesondere elektromagnetische Signale. Bei wenigstens einem der zwischen der zweiten Einrichtung und der ersten Einrichtung übertragenen Signale kann es sich um ein codiertes Betriebssignal zur Authentifikation der zweiten Einrichtung handeln, so dass nach positiver Auswertung des übertragenen Betriebssignals bei berechtigter zweiter Einrichtung eine

Änderung des Zustandes der ersten Einrichtung bewirkbar ist. Die erste Einrichtung wird zum bestimmungsgemäßen Betrieb mit Energie aus dem Akku versorgt. Bei der Komponente, der die Restenergie zur Verfügung gestellt wird, handelt es sich um einen Bestandteil des Schließsystems, und zwar insbesondere der ersten Einrichtung.

Besonders bevorzugt ist in dieser Ausgestaltung, dass es sich bei dem Bestandteil der ersten Einrichtung, das mit der Restenergie versorgt wird, um das Modul für das Fahrberechtigungssystem und/oder für das Zugangsberechtigungssystem, das sogenannte FBS-Modul, das insbesondere in der Türe für das Türschloss befindlich ist, handelt. Über das FBS-Modul kann dann die zweite Einrichtung, also der elektronische Schlüssel, mittels eines Transponders mit wenigstens einem Teil der Restenergie angesteuert werden. In einfacher Art und Weise kann die Spule des Transponders im Türgriff an der Türe oder an sonstiger Position im Außenbereich des Kraftfahrzeugs platziert sein. Bei dieser Ausgestaltung entfällt dann das bisher noch vorhandene mechanische Schloss in der Türe zur Notöffnung, weil die Restenergie im Allgemeinen für mehrere Öffnungsvorgänge ausreichend ist. Da kein teures mechanisches Schloss benötigt wird, wird auch die Kostengünstigkeit mit Hilfe dieser Lösung gesteigert. Außerdem ist auch die Diebstahlsicherheit verbessert, da ein mechanisches Schloss in dieser Hinsicht eine geringere Sicherheit bietet.

Wenigstens ein Teil der Restenergie kann auch zum Betrieb der Fahrzeugelektronik zugeschaltet werden. Hierfür bietet sich in einfacher Art und Weise eine separate Aktivierungseinheit an. Vorteilhafterweise kann dann mindestens ein Startvorgang oder es können auch mehrere Startvorgänge für das Kraftfahrzeug durchgeführt werden. In kostengünstiger Weise ist somit ein Notstart für das Kraftfahrzeug ermöglicht. Es kann sich dabei bei dem Bestandteil der ersten Einrichtung, das mit der Restenergie versorgt wird, um das Steuergerät für das Fahrberechtigungssystem handeln, das sogenannte FBS-Steuergerät. In diesem Fall kann die zweite Einrichtung, also der Schlüssel, mittels eines Transponders über das FBS-Steuergerät mit der Restenergie angesteuert werden. In einfacher und kostengünstiger Weise kann die Spule des Transponders im Armaturenbrett öder an sonstiger Position im Innenbereich des Kraftfahrzeugs platziert sein, womit dem Fahrer eine einfache sowie gut zugängliche Handhabung ermöglicht ist.

Um genügend Restenergie in betriebssicherer Weise zur Verfügung zu haben, kann es sich bei dem Akku um eine Li-Ionen-Batterie handeln.

Die mit der Erfindung erzielten Vorteile bestehen insbesondere darin, dass ein Notbetrieb in einfacher Art und Weise ermöglicht ist. Da der Notbetrieb keine zusätzlichen Komponenten, beispielsweise eine Notbatterie benötigt, fallen hierfür keine zusätzlichen Kosten an. Im Gegenteil können bisher erforderliche zusätzliche, lediglich für den Notfall benötigte Komponenten, beispielsweise ein mechanisches Türschloss, entfallen. Dadurch sind auch weitere Kosteneinsparungen ermöglicht. In kostengünstiger Weise steigert die Erfindung somit die Zuverlässigkeit.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: ein mit einem Schließsystem ausgestattetes Kraftfahrzeug,
- Fig. 2: ein schematisches Blockschaltbild des Schließsystems mit einem Diagramm zur Übertragung der Signale und
- Fig. 3: schematisch eine Energieversorgungsschaltung für elektrische Komponenten im Kraftfahrzeug.

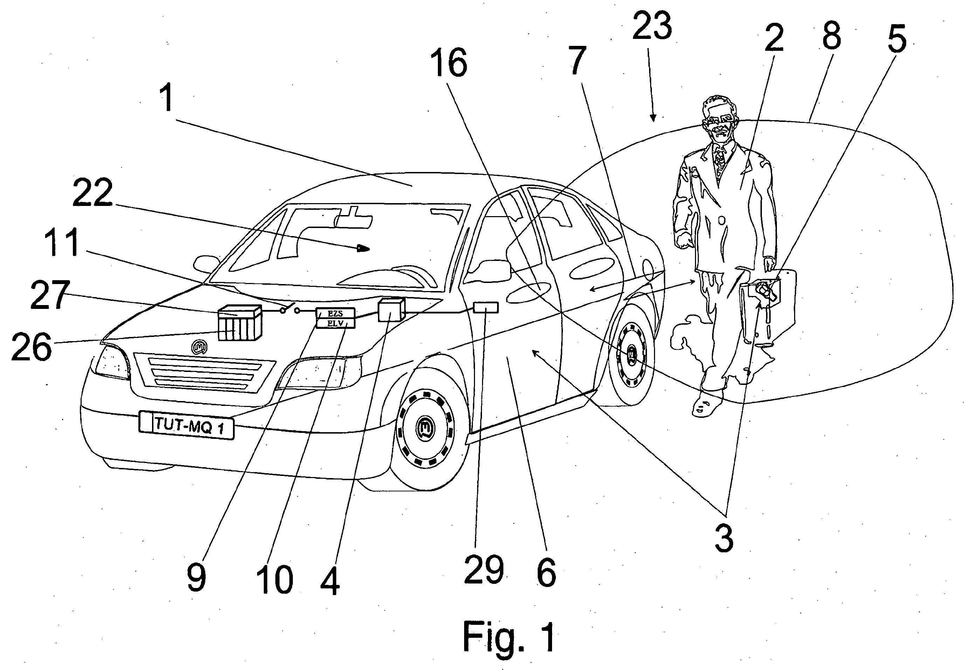

In Fig. 1 ist ein Kraftfahrzeug 1 mit dem berechtigten Benutzer 2 zu sehen. Das Kraftfahrzeug 1 ist für die Zugangsberechtigung mit einem Schließsystem 3 als Türschließsystem versehen, das eine als eine Steuereinrichtung ausgebildete erste Einrichtung 4 und eine zugehörige zweite Einrichtung 5 umfaßt. Die zweite Einrichtung 5 ist in der Art eines elektronischen Schlüssels, eines Identifikations(ID)-Gebers, einer Chipkarte, einer Smartcard o. dgl. ausgebildet. Die zweite Einrichtung 5 befindet sich im Besitz des berechtigten Benutzers 2, womit dieser innerhalb eines Wirkbereichs 8 Zugang zum Kraftfahrzeug 1 besitzt.

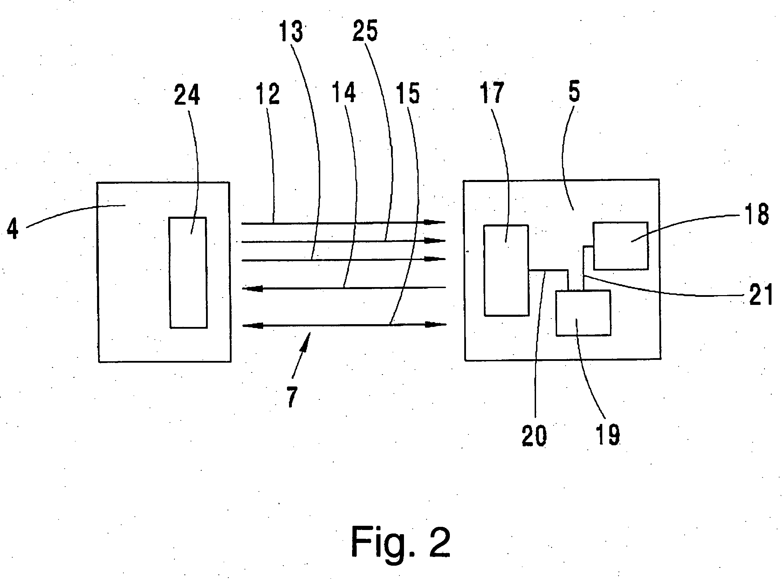

Die erste Einrichtung 4 besitzt wenigstens zwei Zustände, wobei im ersten Zustand eine Verriegelung und im zweiten Zustand eine Entriegelung der Autotüren 6 vorliegt. Die beiden Einrichtungen 4, 5 besitzen zu deren bestimmungsgemäßen Betrieb Mittel zum Senden und/oder Empfangen von Signalen 7 mittels einer elektromagnetischen Trägerwelle. Bei wenigstens einem dieser zwischen der zweiten Einrichtung 5 und der ersten Einrichtung 4 übertragenen Signale 7 handelt es sich um ein codiertes, elektromagnetisches Betriebssignal 15 (siehe Fig. 2). Das codierte Betriebssignal 15 dient zur Authentifikation der zweiten Einrichtung 5, womit bei berechtigter zweiter Einrichtung 5 nach positiver Auswertung des übertragenen Betriebssignals 15 eine Änderung des Zustandes der ersten Einrichtung 4 bewirkbar ist. Die Übertragung des codierten Betriebssignals 15 erfolgt dann, wenn der berechtigte Benutzer 2 den Türgriff 16 an der Autotüre 6 betätigt oder sich dem Türgriff 16 annähert. Dadurch wird die Entriegelung der Autotüren 6 entsprechend der KeylessEntry-Funktionalität ausgelöst. Ebensogut kann die Übertragung des codierten Betriebssignals 15 auch selbsttätig ohne Mitwirkung des Benutzers 2 erfolgen, sobald dieser den Wirkbereich 8 betritt, was jedoch im folgenden nicht näher betrachtet wird. Schließt der Benutzer 2 die Autotüren 6 von außen, so erfolgt eine selbsttätige Verriegelung der Autotüren 6. Ebensogut kann die selbsttätige Verriegelung der Autotüren 6 erfolgen, nachdem der Benutzer 2 den Wirkbereich 8 verlassen hat.

Das Schließsystem 3 stellt weiterhin die Fahrberechtigung für das Kraftfahrzeug 1 fest. Hierzu bewirkt die als Steuereinrichtung ausgebildete erste Einrichtung 4 ebenfalls entsprechend den beiden Zuständen die Ent- und/oder Verriegelung des Zündschlosses 9 (elektronisches Zündschloß EZS) und/oder der Lenkradverriegelung 10 (elektrische Lenkradverriegelung ELV). Ebensogut kann ein sonstiges funktionsrelevantes Bauteil des Kraftfahrzeugs 1 durch die erste Einrichtung 4 dementsprechend angesteuert werden. Beispielsweise kann dadurch eine Freigabe und/oder Sperrung einer Wegfahrsperre, des Motorsteuergeräts o. dgl. erfolgen. Die Übertragung des codierten Betriebssignals 15 zur Authentifikation der zweiten Einrichtung 5 erfolgt dann, wenn der berechtigte Benutzer 2 sich im Kraftfahrzeug 1 befindet und einen Start/Stop-Schalter 11 betätigt. Dadurch wird der Start-Vorgang o. dgl. des Kraftfahrzeugs 1 entsprechend der KeylessGo-Funktionalität ausgelöst.

Die Übertragung der Signale 7 für die KeylessEntry/Go-Funktionalität wird durch Betätigung eines Schalters und/oder eines Sensors vom Benutzer 2 ausgelöst. Für die Zugangsberechtigung kann es sich beispielsweise um die manuelle Betätigung des Türgriffs 16, des Heckgriffs o. dgl. handeln. Für die Fahrberechtigung befindet sich der vom Benutzer 2 manuell betätigbare Start/Stop-Schalter 11 im Kraftfahrzeug 1. Zweckmäßigerweise ist der Start/Stop-Schalter 11 am Gangwahlhebel, am Zündschloß 9, im Armaturenbrett, in der Mittelkonsole o. dgl. im Kraftfahrzeug 1 angeordnet.

Die Funktionsweise des erfindungsgemäßen Schließsystems 3 soll nun anhand der Fig. 2 näher erläutert werden.

Zunächst sendet die erste Einrichtung 4 mittels eines Senders/Empfängers 24 als Mittel zum Senden und/oder Empfangen von Signalen ein als Wecksignal bezeichnetes erstes elektromagnetisches Signal 12 für die zugehörige zweite Einrichtung 5. Durch das Wecksignal 12 wird die zweite Einrichtung 5 aus einem Ruhezustand mit verringertem Energiebedarf in einen aktivierten Zustand für den bestimmungsgemäßen Betrieb übergeführt. Danach sendet die erste Einrichtung 4 wenigstens ein weiteres, drittes elektromagnetisches Signal 13, das nachfolgend auch als Bereichsabgrenzungssignal bezeichnet ist. Dadurch kann die zugehörige zweite Einrichtung 5 deren Standort in Bezug auf die erste Einrichtung 4 bestimmen. Insbesondere lässt sich feststellen, ob die zweite Einrichtung 5 außerhalb am Kraftfahrzeug 1 sowie gegebenenfalls an welcher Stelle des Außenraums 23 und/oder im Innenraum 22 des Kraftfahrzeugs 1 befindlich ist. Nachfolgend sendet die zweite Einrichtung 5 mittels eines Senders/Empfängers 17 ein die Information zum ermittelteten Standort beinhaltendes viertes Signal 14 zur ersten Einrichtung 4, das im folgenden auch als Rückantwortsignal bezeichnet ist. Schließlich wird dann, wie bereits beschrieben, das fünfte elektromagnetische Signal als codiertes elektromagnetisches Betriebssignal 15 zur Authentifikation mittels der Sender/Empfänger 24 17 zwischen der ersten und der zweiten Einrichtung 4, 5 übertragen. Das Signal 15 kann insbesondere aus mehreren Teilsignalen bestehen und in einer bidirektionalen Kommunikation zwischen den beiden Einrichtungen 4, 5 übertragen werden. Im Hinblick auf nähere Einzelheiten zur bidirektionalen Kommunikation an sich wird auch auf die DE 43 40 260 A1 verwiesen.

Das Wecksignal 12 kann beispielsweise eine Kennung zum Kraftfahrzeug-Typ enthalten. Nach Empfang des Wecksignals 12 sind zunächst sämtliche im Wirkbereich 8 befindliche zweite Einrichtungen 5, die zum selben Kraftfahrzeug-Typ gehören, aktiviert. In einer weiteren Ausgestaltung des Schließsystems 3 sendet die erste Einrichtung 4 zwischen dem ersten Signal 12 und dem dritten Signal 13 ein zweites elektromagnetisches Signal 25 zur zweiten Einrichtung 5 als Selektionssignal, wie näher anhand von Fig. 2 zu erkennen ist. Das zweite Signal 25 enthält eine Information über die nähere Identität des Kraftfahrzeugs 1. Dadurch wird bewirkt, dass lediglich die tatsächlich zur ersten Einrichtung 4 zugehörigen zweiten Einrichtungen 5 im aktivierten Zustand verbleiben. Im aktivierten Zustand befindliche, nicht zum Kraftfahrzeug 1 zugehörige zweite Einrichtungen werden jedoch in den Ruhezustand zurückgeführt.

Die zweite Einrichtung 5, die als schematisches Blockschaltbild in Fig. 2 gezeigt ist, weist den Sender/Empfänger 17 als Mittel zum Senden und/oder Empfangen von Signalen und eine beispielsweise aus einem Mikrocomputer bestehende Logikschaltung 18 auf. Weiter ist in der zweiten Einrichtung 5 ein Mittel 19 zur Messung der Feldstärke wenigstens eines von der ersten Einrichtung 4 übertragenen Signals angeordnet. Das Mittel 19 zur Messung der Feldstärke misst die Feldstärke beziehungsweise die Intensität eines der übertragenen Signale, und zwar des Bereichsabgrenzungssignals 13. Zweckmäßigerweise ist das Mittel 19 zur Messung der Feldstärke als ein integrierter Baustein ausgestaltet, der nachfolgend auch als RSS(Radio Signal Strength)-Chip bezeichnet ist. Der RSS-Chip 19 besitzt einen Eingang 20, der mit dem Sender/Empfänger 17 verbunden ist, sowie einen RSSI(Radio Signal Strength Indicator)-Ausgang 21, der wiederum mit der Logikschaltung 18 verbunden ist. Der RSS-Chip 19 erhält über den Eingang 20 das vom Sender/Empfänger 17 jeweils empfangene Signal 13 und erzeugt an seinem RSSI-Ausgang 21 ein in funktioneller Abhängigkeit zur Feldstärke des Signals 13 stehendes RSSI-Signal. Beispielsweise kann das RSSI-Signal proportional oder logarithmisch zur Feldstärke des Signals 13 abhängig sein. Durch entsprechende Auswertung des RSSI-Signals lässt sich dann die Standortbestimmung in der Logikschaltung 18 vornehmen.

Besonders bevorzugt ist, dass die Trägerwelle für das erste Signal 12 als Wecksignal und/oder für das dritte Signal 13 als Bereichsabgrenzungsignal eine im induktiven, niederfrequenten (NF-)Bereich liegende Frequenz aufweist. Beispielsweise kann diese Frequenz in etwa 20 kHz, 120 kHz, 125 kHz o. dgl. betragen. Vorteilhafterweise weist ein solches induktives Signal eine auf die unmittelbare Umgebung des Kraftfahrzeugs 1 begrenzte Reichweite auf. Dadurch wird erreicht, dass die zweite Einrichtung 5 lediglich dann aktiviert wird, wenn sie im Innenraum 22 des Kraftfahrzeugs 1 oder im Wirkbereich 8 im Außenraum 23 am Kraftfahrzeug 1 befindlich ist, womit Störungen und/oder Sicherheitslücken durch Überreichweiten vermieden sind. Falls gewünscht kann auch das zweite Signal 25, welches in Fig. 2 gezeigt ist, eine im niederfrequenten (NF-)Bereich liegende Frequenz aufweisen. Es ist jedoch besonders bevorzugt, dass die Trägerwelle für das zweite Signal 25 als Selektionssignal und/oder für das vierte Signal 14 als Rückantwortsignal und/oder für das fünfte Signal 15 als Betriebssignal eine im höherfrequenten (RF-)Bereich liegende Frequenz aufweist. Beispielsweise kann diese Frequenz in etwa 315 MHz, 433 MHz, 868 MHz o. dgl. betragen.

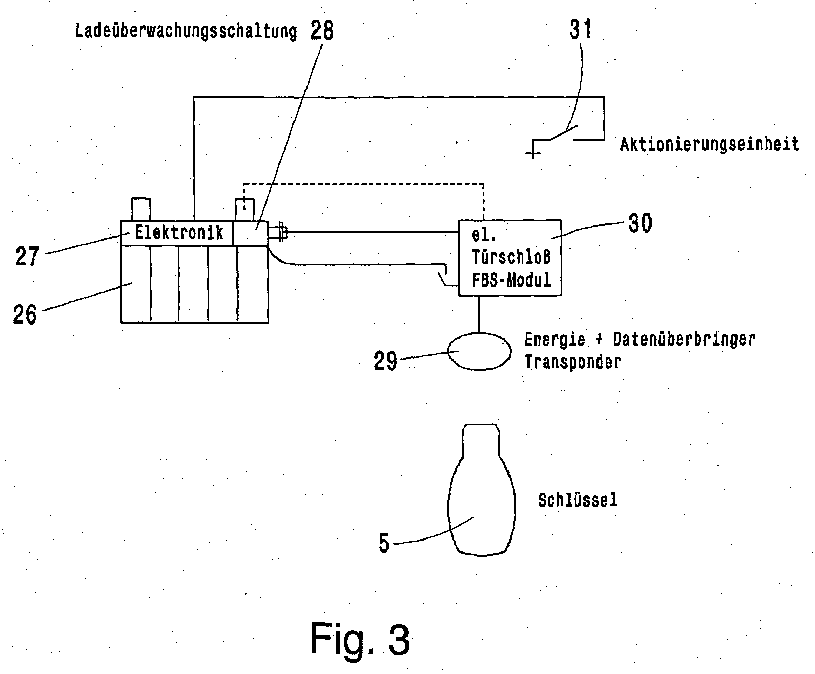

Wie in Fig. 1 weiter zu sehen ist, besitzt das Kraftfahrzeug 1 einen Akku 26, welcher in üblicher Weise auch als Batterie bezeichnet wird. Bei dem Akku 26 kann es sich um eine Lithium-Ionen-Batterie handeln, die durch eine besondere Leistungsfähigkeit ausgezeichnet ist. Der Akku 26 versorgt diverse elektrische Komponenten im Kraftfahrzeug 1 mit Energie zu deren Betrieb. Im Akku 26 befindet sich zu diesem Zweck eine Energieversorgungsschaltung 27 in der Art einer Elektronik, über die die elektrischen Komponenten mit elektrischer Spannung und/oder elektrischem Strom versorgt werden. Vor allem wird auch die erste Einrichtung 4 im Kraftfahrzeug zu deren bestimmungsgemäßen Betrieb mit Energie aus dem Akku 26 versorgt. Eine schematisch in Fig. 3 gezeigte Entladeüberwachungsschaltung 28 in der Stromversorgungsschaltung 27 überwacht die im Akku 26 gespeicherte Energie. Die Entladeüberwachungsschaltung 28 schaltet bei Unterschreiten eines Grenzwertes für die im Akku 26 gespeicherte Energie die Spannungs- und/oder Stromversorgung zumindest einzelner Komponenten im Kraftfahrzeug 1 ab. Bevorzugterweise kann in diesem Fall die Spannungsversorgung aller Komponenten abgeschaltet werden.

Ist die Spannungs- und/oder Stromversorgung aufgrund geringer Energie im Akku 26 abgeschaltet, so kann die im Akku 26 enthaltene Restenergie auf Anforderung einer Komponente zur Verfügung gestellt werden, um einen Notbetrieb für das Kraftfahrzeug 1 zu ermöglichen. Bei der Komponente, der die Restenergie zur Verfügung gestellt wird, handelt es sich um einen Bestandteil des Schließsystems 3, insbesondere der ersten Einrichtung 4. Und zwar handelt es sich bei diesem mit der Restenergie versorgten Bestandteil der ersten Einrichtung 4 um das Modul 30 für das Fahrberechtigungssystem und/oder für das Zugangsberechtigungssystem im elektrischen Türschloss für die Autotüre 6 (FBS-Modul).

Wie man weiter anhand der Fig. 3 sieht, wird über das FBS-Modul 30 die zweite Einrichtung 5, also der elektronische Schlüssel, über einen Transponder 29 mit der Restenergie angesteuert. Die Spule des Transponders 29 kann im Türgriff 16 oder entsprechend Fig. 1 auch an sonstiger Position im Außenbereich des Kraftfahrzeugs 1 platziert sein. Dabei entfällt nun das bisher benötigte mechanische Schloss in der Autotüre 6 für die Notöffnung des Kraftfahrzeugs 1, weil durch entsprechende Wahl des Grenzwertes für die im Akku 26 gespeicherte Energie die Restenergie für mehrere Öffnungsvorgänge der Autotüre 6 ausreichend ist, um so Zugang zum Kraftfahrzeug 1 für den Benutzer 2 zu erhalten.

Desweiteren kann gewünscht sein, dass nicht nur der Zugang zum Kraftfahrzeug 1 im Notfall sondern auch ein Notbetrieb des Kraftfahrzeugs 1 ermöglicht ist. Hierzu kann die Restenergie des Akkus 26 über eine separate Aktivierungseinheit 31 zum Betrieb der Fahrzeugelektronik zugeschaltet werden. Dadurch kann mindestens ein Startvorgang für das Kraftfahrzeug 1 vom Benutzer 2 gemacht werden. Selbstverständlich kann durch entsprechende Festlegung des Grenzwertes für die im Akku 26 gespeicherte Energie die Restenergie so bemessen sein, dass mehrere Startvorgänge für das Kraftfahrzeug 1 durchgeführt werden können.

Zur Durchführung des Startvorgangs im Notfall kann es sich dann bei dem Bestandteil der ersten Einrichtung 4, das mit der Restenergie versorgt wird, um das Steuergerät für das Fahrberechtigungssystem handeln, das sogenannte FBS-Steuergerät. Über das FBS-Steuergerät wird dann die zweite Einrichtung 5, also der Schlüssel, mittels eines Transponders mit der Restenergie angesteuert. Die Spule des Transponders kann im Armaturenbrett oder an sonstiger Position im Innenbereich des Kraftfahrzeugs 1 platziert sein, was allerdings nicht weiter gezeigt ist.

Die Erfindung ist nicht auf das beschriebene und dargestellte Ausführungsbeispiel beschränkt. Sie umfasst vielmehr auch alle fachmännischen Weiterbildungen im Rahmen der Schutzrechtsansprüche. So kann ein derartiges Schließsystem nicht nur im Kraftfahrzeug eingesetzt werden. Es ist auch eine Verwendung für ein sonstiges Türschloss, das sich beispielsweise an einer Immobilie o. dgl. befindet, möglich. Schließlich kann die Energieversorgungsschaltung auch zur Strom- und/oder Spannungsversorgung sonstiger Komponenten in elektrischen Anlagen, elektrischen Maschinen, in der Hausinstallation o. dgl. eingesetzt werden, wobei bei Unterschreiten eines Grenzwertes für die im Akku gespeicherte Energie die Strom- und/oder Spannungsversorgung zumindest einzelner Komponenten abgeschaltet wird. In einem solchen Notfall kann dann die im Akku enthaltene Restenergie auf Anforderung einer Komponente oder auch mehreren Komponenten bestimmungsgemäß zur Verfügung gestellt werden.

Bezugszeichen-Liste:
- 1:: Kraftfahrzeug / Fahrzeug
- 2:: (berechtigter) Benutzer
- 3:: Schließsystem
- 4:: erste Einrichtung
- 5:: zweite Einrichtung
- 6:: Autotüre / Türe
- 7:: Signal
- 8:: Wirkbereich
- 9:: Zündschloß
- 10:: Lenkradverriegelung
- 11:: Start/Stop-Schalter
- 12:: (erstes) Signal / Wecksignal
- 13:: (drittes) Signal / Bereichsabgrenzungssignal
- 14:: (viertes) Signal / Rückantwortsignal
- 15:: (fünftes) Signal / (codiertes) Betriebssignal
- 16:: Türgriff
- 17:: Sender/Empfänger (in der zweiten Einrichtung)
- 18:: Logikschaltung / Mikroprozessor
- 19:: Mittel zur Messung der Feldstärke / RSS-Chip
- 20:: Eingang (von RSS-Chip)
- 21:: RSSI-Ausgang (an RSS-Chip)
- 22:: Innenraum (vom Kraftfahrzeug)
- 23:: Außenraum (vom Kraftfahrzeug)
- 24:: Sender/Empfänger (in der ersten Einrichtung)
- 25:: (zweites) Signal / Selektionssignal
- 26:: Akku
- 27:: Energieversorgungsschaltung
- 28:: Entladeüberwachungsschaltung
- 29:: Transponder
- 30:: Modul / FBS-Modul
- 31:: Aktivierungseinheit

## Patentansprüche

1. Energieversorgungsschaltung von elektrischen Komponenten für ein Kraftfahrzeug (1), wobei das Kraftfahrzeug (1) ein Schließsystem (3) für die Zugangs- und/oder Fahrberechtigung aufweist, mit einem Akku (26), der die elektrischen Komponenten mit Energie zu deren Betrieb versorgt, und mit einer Entladeüberwachungsschaltung (28), die die im Akku (26) gespeicherte Energie überwacht, wobei die Entladeüberwachungsschaltung (28) bei Unterschreiten eines Grenzwertes für die im Akku (26) gespeicherte Energie die Energieversorgung zumindest einzelner Komponenten, insbesondere aller Komponenten, abschaltet, **dadurch gekennzeichnet, dass** die im Akku (26) enthaltene Restenergie nach Abschalten der Energieversorgung auf Anforderung einer Komponente für den Notbetrieb zur Verfügung gestellt wird, wobei es sich bei der Komponente, der die Restenergie zur Verfügung gestellt wird, um ein Bestandteil des Schließsystems (3) handelt.

2. Energieversorgungsschaltung nach Anspruch 1, **dadurch gekennzeichnet, dass** das Schließsystem (3) eine wenigstens zwei Zustände besitzende, als Steuereinrichtung ausgebildete erste Einrichtung (4), wie eine Steuereinrichtung zur Ent- und/oder Verriegelung der Autotüren (6), des Zündschlosses (9), der Lenkradverriegelung (10), zur Freigabe und/oder Sperrung der Wegfahrsperre, des Motorsteuergeräts o. dgl., und eine zugehörige, in der Art eines elektronischen Schlüssels, eines ID-Gebers, einer Chipkarte o. dgl. ausgebildete zweite Einrichtung (5) umfasst, wobei die beiden Einrichtungen (4, 5) zu deren bestimmungsgemäßen Betrieb Sender und/oder Empfänger (24, 17) für insbesondere elektromagnetische Signale (7) besitzen, wobei es sich insbesondere bei wenigstens einem der zwischen der zweiten Einrichtung (5) und der ersten Einrichtung (4) übertragenen Signale (7) um ein codiertes Betriebssignal (15) zur Authentifikation der zweiten Einrichtung (5) handelt, so dass nach positiver Auswertung des übertragenen Betriebssignals (15) bei berechtigter zweiter Einrichtung (5) eine Änderung des Zustandes der ersten Einrichtung (4) bewirkbar ist, und wobei die erste Einrichtung (4) zum bestimmungsgemäßen Betrieb mit Energie aus dem Akku (26) versorgt wird, und dass es sich bei der Komponente, der die Restenergie zur Verfügung gestellt wird, insbesondere um die erste Einrichtung (4) handelt.

3. Energieversorgungsschaltung nach Anspruch 2, **dadurch gekennzeichnet, dass** es sich bei dem Bestandteil der ersten Einrichtung (4), das mit der Restenergie versorgt wird, um das Modul (30) für das Fahrberechtigungssystem und/oder für das Zugangsberechtigungssystem, insbesondere in der Türe (6) für das Türschloss, handelt.

4. Energieversorgungsschaltung nach Anspruch 2 oder 3, **dadurch gekennzeichnet, dass** die zweite Einrichtung (5) mittels eines Transponders (29) über das (FBS-)Modul (30) für das Fahrberechtigungssystem und/oder für das Zugangsberechtigungssystem mit der Restenergie angesteuert wird, und dass vorzugsweise die Spule des Transponders (29) im Türgriff (16) an der Türe (6) oder an sonstiger Position im Außenbereich des Kraftfahrzeugs (1) platziert ist.

5. Energieversorgungsschaltung nach einem der Ansprüche 1 bis 4, **dadurch gekennzeichnet, dass** die Restenergie, insbesondere über eine separate Aktivierungseinheit (31), zum Betrieb der Fahrzeugelektronik zugeschaltet wird, so dass mindestens ein Startvorgang für das Kraftfahrzeug (1) durchgeführt werden kann.

6. Energieversorgungsschaltung nach einem der Ansprüche 2 bis 5, **dadurch gekennzeichnet, dass** es sich bei dem Bestandteil der ersten Einrichtung (4), das mit der Restenergie versorgt wird, um das Steuergerät für das Fahrberechtigungssystem handelt, dass vorzugsweise die zweite Einrichtung (5) mittels eines Transponders über das Steuergerät für das Fahrberechtigungssystem mit der Restenergie angesteuert wird, und dass weiter vorzugsweise die Spule des Transponders im Armaturenbrett oder an sonstiger Position im Innenbereich des Kraftfahrzeugs (1) platziert ist.

7. Energieversorgungsschaltung nach einem der Ansprüche 1 bis 6, **dadurch gekennzeichnet, dass** es sich bei dem Akku (26) um eine Li-Ionen-Batterie handelt.

## Claims

1. An energy supply circuit for electric components for a motor vehicle (1), wherein the motor vehicle (1) has a locking system (3) for access- and/or driving authorization, comprising a rechargeable battery (26), which provides the electric components with energy for their operation, and with a discharge monitoring circuit (28), which monitors the energy stored in the rechargeable battery (26), wherein should the energy stored in the rechargeable battery (26) fall below a threshold value, the discharge monitoring circuit (28) switches off the energy supply of at least some components, in particular all components, **characterized in that** the residual energy contained in the rechargeable battery (26) after switching off the energy supply is made available on request to a component for emergency operation, wherein the component, to which residual energy is provided, is a part of the locking system (3).

2. An energy supply circuit according to Claim 1, **characterized in that** the locking system (3) comprises a first device (4) designed as a control device, having at least two states, such as a control device for the unlocking and/or locking of the car doors (6), the ignition lock (9), the steering wheel lock (10), for the release and/or locking of the vehicle immobilizer, the engine control unit or the like, and an associated second device (5) designed in the manner of an electronic key, an ID transmitter, a chip card or the like, wherein for their intended operation the two devices (4, 5) have a transmitter and/or a receiver (24, 17) for particular electromagnetic signals (7), wherein in particular at least one of the signals transmitted between the second device (5) and the first device (4) is a coded operational signal (15) for the authentication of the second device (5), so that after a positive evaluation of the transmitted operational signal (15) in the case of the authorized second device (5) a change in the state of the first device (4) can be effected, and wherein the first device (4) is provided with energy from the rechargeable battery (26) for the intended operation, and that the component, to which the residual energy is provided, is in particular the first device (4).

3. An energy supply circuit according to Claim 2, **characterized in that** the part of the first device (4) which is provided with the residual energy, is the module (30) for the driving authorization system and/or for the access authorization system, in particular in the door (6) for the door lock.

4. An energy supply circuit according to Claim 2 or 3, **characterized in that** the second device (5) is actuated by means of a transponder (29) via the (FBS-)module (30) for the driving authorization system and/or for the access authorization system with the residual energy, and that preferably the coil of the transponder (29) is placed in the door handle (16) on the door (6) or at another position in the outer area of the motor vehicle (1).

5. An energy supply circuit according to any one of Claims 1 to 4, **characterized in that** the residual energy, is switched on in particular via a separate activation unit (31) for the operation of the motor vehicle electronics, so that at least one start process can be carried out for the motor vehicle (1).

6. An energy supply circuit according to any one of Claims 2 to 5, **characterized in that** the part of the first device (4), which is provided with residual energy, is the control device for the driving authorization system, that preferably the second device (5) is actuated by means of a transponder via the control device for the driving authorization system with the residual energy, and that furthermore preferably the coil of the transponder is placed in the dashboard or at another position in the interior area of the motor vehicle (1).

7. An energy supply circuit according to any one of Claims 1 to 6, **characterized in that** the rechargeable battery (26) is a Li-ion battery.

## Revendications

1. Circuit d'alimentation en énergie de composants électriques pour un véhicule automobile (1), le véhicule automobile (1) comprenant un système de fermeture (3) pour l'autorisation d'accès et/ou de conduite, avec un accumulateur (26), qui alimente en énergie les composants électriques pour leur fonctionnement, et avec un circuit de surveillance de décharge (28) qui surveille l'énergie stockée dans l'accumulateur (26), le circuit de surveillance de décharge (28) coupe l'alimentation en énergie d'au moins certains composants, plus particulièrement de tous les composants, lors du passage en dessous d'une valeur limite pour l'énergie stockée dans l'accumulateur (26), **caractérisé en ce que** l'énergie résiduelle contenue dans l'accumulateur (26) est mise à disposition, après la coupure de l'alimentation en énergie sur demande d'un composant pour le fonctionnement d'urgence, les composants auxquels l'énergie résiduelle est mise à disposition faisant partie du système de fermeture (3).

2. Circuit d'alimentation en énergie selon la revendication 1, **caractérisé en ce que** le système de fermeture (3) comprend un premier dispositif (4) présentant deux états et conçu comme un dispositif de commande, comme un dispositif de commande pour le déverrouillage et/ou le verrouillage des portières (6), du contacteur d'allumage (9), du verrouillage du volant (10), pour la libération et/ou le blocage de la protection antidémarrage, du dispositif de commande du moteur ou autre, et un deuxième dispositif (5) correspondant, conçu à la manière d'une clé électronique, d'un générateur d'identifiants, d'une carte à puce ou autre, les deux dispositifs (4, 5) comprenant, pour leur fonctionnement conforme à l'usage prévu, des émetteurs et/ou des récepteurs (24, 17) plus particulièrement pour des signaux électromagnétiques (7), au moins un des signaux (7) transmis entre le deuxième dispositif (5) et le premier dispositif (4) étant un signal de fonctionnement codé (15) pour l'authentification du deuxième dispositif (5), de façon à ce que, après une analyse positive du signal de fonctionnement (15) transmis, lorsque le deuxième dispositif (5) est autorisé, une modification de l'état du premier dispositif (4) puisse être provoquée et le premier dispositif (4) étant alimenté, pour son fonctionnement conforme à l'usage prévu, en énergie provenant de l'accumulateur (26), et **en ce que** le composant auquel l'énergie résiduelle est mise à disposition est le premier dispositif (4).

3. Circuit d'alimentation en énergie selon la revendication 2, **caractérisé en ce que** le composant du premier dispositif (4) qui est alimenté en énergie résiduelle est le module (30) pour le système d'autorisation de conduite et/ou pour le système d'autorisation d'accès, plus particulièrement dans la portière (6) pour la serrure.

4. Circuit d'alimentation en énergie selon la revendication 2 ou 3, **caractérisé en ce que** le deuxième dispositif (5) est piloté au moyen d'un transpondeur (29) par l'intermédiaire du module (FBS) (30) pour le système d'autorisation de conduite et/ou pour le système d'autorisation d'accès avec l'énergie résiduelle, et **en ce que**, de préférence, la bobine du transpondeur (29) est positionnée dans la poignée (16) sur la portière (6) ou à une autre position à l'extérieur du véhicule automobile (1).

5. Circuit d'alimentation en énergie selon l'une des revendications 1 à 4, **caractérisé en ce que** l'énergie résiduelle est commutée, plus particulièrement par l'intermédiaire d'une unité d'activation séparée (31), pour le fonctionnement de l'électronique du véhicule, de façon à ce qu'au moins un processus de démarrage puisse être effectué pour le véhicule automobile (1).

6. Circuit d'alimentation en énergie selon l'une des revendications 2 à 5, **caractérisé en ce que** le composant du premier dispositif (4) alimenté en énergie résiduelle est l'appareil de commande pour le système d'autorisation de conduite, **en ce que**, de préférence, le deuxième dispositif (5) est piloté au moyen d'un transpondeur par l'intermédiaire de l'appareil de commande pour le système d'autorisation de conduite en énergie résiduelle, et **en ce que**, en outre, de préférence, la bobine du transpondeur est positionnée dans le tableau de bord ou à une autre position à l'intérieur du véhicule automobile (1).

7. Circuit d'alimentation en énergie selon l'une des revendications 1 à 6, **caractérisé en ce que** l'accumulateur (26) est une batterie lithium-ion.
